# EUROPÄISCHE PATENTANMELDUNG

(11) **EP 2 818 876 A1**
(43) Veröffentlichungstag der Anmeldung: **31.12.2014**
(21) Anmeldenummer: 13173343.8
(22) Anmeldetag: 24.06.2013
(51) Int. Cl.: G01R 15/00, G01R 31/00

(54) **Transformatoranordnung und Verfahren zum Betreiben einer Transformatoranordnung**

(71) Anmelder: Omicron electronics GmbH, 6833 Klaus (AT)
(72) Erfinder: Unterer, Boris, 6800 Feldkirch (AT); de Villiers, Wernich, 6850 Dornbirn (AT)
(74) Vertreter: Banzer, Hans-Jörg

(57) **Zusammenfassung**

Eine Transformatoranordnung, welche einen Eingangsanschluss (13) zum Empfangen eines Eingangssignals und einen Transformator mit einer Primärwicklung (5) und einer Sekundärwicklung (6) umfasst, kann wahlweise als Trenntransformator oder als Messtransformator betrieben werden, indem wahlweise in einem ersten Betriebsmodus die Primärwicklung (5) des Transformators mit dem Eingangsanschluss (13) verbunden wird oder die Primärwicklung (5) in einem zweiten Betriebsmodus von dem Eingangsanschluss getrennt wird, und indem wahlweise die Sekundärwicklung (6) des Transformators in dem ersten Betriebsmodus mit einer Versorgungsspannungsquelle (1) verbunden wird oder in dem zweiten Betriebsmodus von der Versorgungsspannungsquelle (1) getrennt wird.

## Beschreibung

Die vorliegende Erfindung betrifft eine Transformatoranordnung und ein Verfahren zum Betreiben einer Transformatoranordnung, insbesondere einer zum Einsatz in einem Mess- oder Testgerät für energietechnische Einrichtungen oder Komponenten geeigneten Transformatoranordnung.

Herkömmliche Systeme zur Umformung von Spannungen und Strömen lassen sich in Systeme mit und ohne eine galvanische Trennung unterteilen. Bei Systemen mit einer galvanischen Trennung werden potentialfreie Verbindungen verwendet, die unter anderem dafür eingesetzt werden, um die Gefahr einer Berührung einer Betriebsspannung zu verhindern und die Sicherheit des entsprechenden Systems zu erhöhen ("Schutztrennung"). Des Weiteren wird bei einem System mit galvanischer Trennung eine Übertragung von elektromagnetischen Störungen von einem System in ein damit gekoppeltes weiteres System vermieden.

Potentialfreie Wandler für Wechselspannungen oder Wechselströme bzw. für höhere Leistungen sind meist durch induktive Trennung in Form von Transformatoren realisiert. Solche Transformatoren weisen oft verschiedene Abgriffe auf, um Übersetzungsverhältnisse besser auf die Anwendungen anpassen zu können.

Bei Transformatorschaltungen kann unterschieden werden zwischen Systemen, bei denen beide gekoppelten und potentialfreien Wechselspannungs- bzw. Wechselstromsysteme an dieselbe Frequenz gebunden sind und Systeme, die mit unabhängigen Frequenzen betrieben werden.

Systeme, die mit unabhängigen Frequenzen betrieben werden, bieten ein weites Anwendungsspektrum, da sie die Funktionen von Spannungs-, Strom-und Frequenzumformern in sich vereinen, wobei in der Praxis jedoch der Frequenzbereich durch das Übertragungsspektrum des verwendeten Transformators begrenzt ist.

Ein Beispiel für eine derartige Transformatoranordnung ist in DE 100 48 962 B4 der Anmelderin offenbart und umfasst einen Transformator mit einer Primärwicklung und mindestens einer Sekundärwicklung, wobei der Primärwicklung ein von einer Versorgungsspannungsquelle bereitgestelltes Eingangssignal über ein Filter und einen steuerbaren Verstärker zugeführt wird. Der Verstärker wird von einer Steuerung in Abhängigkeit von einem an der jeweiligen aktiven Sekundärwicklung auftreten Ausgangssignal gesteuert. Darüber hinaus ist zwischen dem Verstärker und der Primärwicklung des Transformators ein steuerbarer Schalter vorgesehen, mit dessen Hilfe das von dem Verstärker bereitgestellte Signal direkt über einen separaten Booster-Ausgang der Transformatoranordnung ausgegeben werden kann. Der Booster-Ausgang ist in dieser Anordnung vom Netz nicht galvanisch getrennt.

Um isolierte Gleichstrom- oder Gleichspannungssignale bzw. einen erweiterten Frequenzbereich erzeugen zu können, kann einem derartigen System ein zusätzlicher Trenntransformator vorgeschaltet werden. Als Alternative kann, um eine erhöhte Leistung aus dem System zu ziehen, ein Trenntransformator dem Booster-Ausgang nachgeschaltet werden. In beiden Fällen ist jedoch der Einsatz eines derartigen Trenntransformators mit zusätzlichen Kosten verbunden, wobei er sich darüber hinaus nachteilig auf das Gesamtgewicht des entsprechenden Geräts auswirkt und somit die Beförderung aufwändiger wird. Zudem kann dabei der eingebaute Transformator, der bei Verwendung in einem Messgerät als Messtransformator dient, nicht verwendet werden, da bei Verwendung des zusätzlichen Trenntransformators der Ausgang des Verstärkers über den zuvor beschriebenen steuerbaren Schalter mit dem Booster-Ausgang verbunden und daher von der Primärwicklung des Messtransformators getrennt ist.

Der vorliegenden Erfindung liegt somit die Aufgabe zugrunde, eine kostengünstige, das Gesamtgewicht nicht erhöhende Transformatoranordnung bereitzustellen, mit welcher auf einfache Art und Weise isolierte Gleichstromsignale (DC-Signale) und ein erweiterter Frequenzbereich erzeugt werden kann und zudem eine erhöhte Leistung erzielt wird.

Diese Aufgabe wird durch eine Transformatoranordnung gemäß Anspruch 1 und ein Verfahren zum Betreiben einer Transformatoranordnung gemäß Anspruch 10 gelöst. Die abhängigen Ansprüche definieren bevorzugte und vorteilhafte Ausführungsformen der Erfindung.

Die erfindungsgemäße Transformatoranordnung umfasst einen Eingangsanschluss zum Empfangen eines Eingangssignals, einen Transformator mit einer Primärwicklung und einer oder mehreren Sekundärwicklungen, Steuermittel zum Steuern der Transformatoranordnung und steuerbare Schaltvorrichtungen, welche von den Steuermitteln derart angesteuert werden, dass die Primärwicklung des Transformators wahlweise mit dem Eingangsanschluss verbunden oder davon getrennt werden kann und eine Sekundärwicklung des Transformators wahlweise mit einer Versorgungsspannungsquelle verbunden oder davon getrennt werden kann.

Die Betätigung der Schaltvorrichtungen erfolgt abhängig von dem gewünschten Betriebsmodus der Transformatoranordnung, so dass der Transformator der Transformatoranordnung abhängig von dem Zustand der Schaltvorrichtungen entweder als Trenntransformator oder als Messtransformator betrieben werden kann. Auf diese Weise wird mit einfachen Mitteln und kostengünstig ohne Erhöhung des Gewichtes eine vielseitig für mehrere unterschiedliche Betriebsmodi nutzbare Transformatoranordnung realisiert.

Die Steuermittel können eine digitalen Signalprozessor, einen Mikroprozessor, Mikrocontroller oder andere digitale Steuerlogik umfassen.

Gemäß einer bevorzugten Ausführungsform der Erfindung wird das Eingangssignal der Primärwicklung des Transformators über eine Reihenschaltung aus einem Filter und einem Verstärker zugeführt, wobei der Verstärker insbesondere von den Steuermitteln in Abhängigkeit von einem Ausgangssignal an der Sekundärwicklung des Transformators gesteuert wird, um die Verstärkung entsprechend anzupassen.

Die Transformatoranordnung kann eine weitere steuerbare Schaltvorrichtung umfassen, um den Ausgang des Verstärkers wahlweise mit der Primärwicklung des Transformators oder mit einem separaten Booster-Ausgang der Transformatoranordnung zu verbinden.

Die erfindungsgemäße Transformatoranordnung ist insbesondere derart ausgestaltet, dass sie zum Einsatz in einem Mess- oder Testgerät für energietechnische Einrichtungen geeignet ist, wobei mit Hilfe der Transformatoranordnung das Eingangssignal in ein geeignetes Mess- oder Testsignal umgesetzt wird.

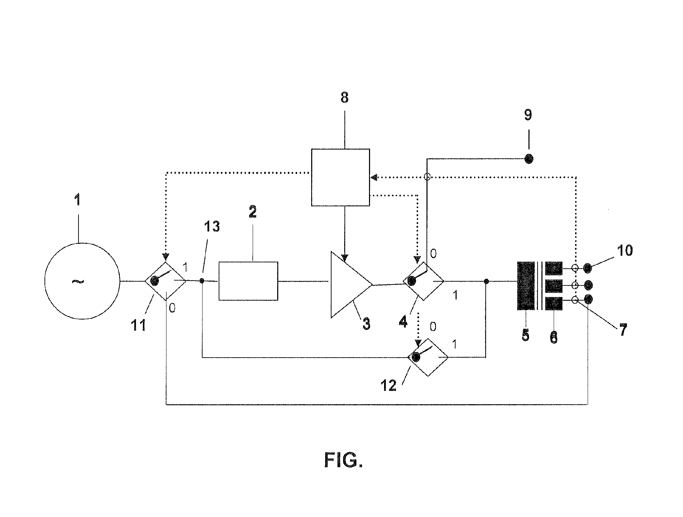

Die vorliegende Erfindung wird nachfolgend näher anhand eines bevorzugten Ausführungsbeispiels unter Bezugnahme auf die beigefügte Zeichnung erläutert.

In der einzigen Figur sind die Bestandteile einer Transformatoranordnung gemäß einem bevorzugten Ausführungsbeispiel der vorliegenden Erfindung dargestellt, wobei die dargestellten Bestandteile allesamt in einem gemeinsamen (nicht gezeigten) Gehäuse untergebracht sind. Die Transformatoranordnung ist insbesondere zum Einsatz in einem Mess- oder Testgerät für energietechnische Einrichtungen oder Komponenten geeignet, um ein von einer Spannungsquelle erzeugtes Signal in ein geeignetes Mess-oder Testsignal mit gewünschter Amplitude und Frequenz umzusetzen.

Bei dem dargestellten Ausführungsbeispiel ist ein Eingangsanschluss 13 der Transformatoranordnung mit einem Filter 2 und einem steuerbaren Verstärker 3 verbunden, wobei der Eingangsanschluss 13 über eine steuerbare Schaltvorrichtung 11, welche in Form von einem Relais realisiert sein kann, wahlweise mit einer Spannungsquelle 1 gekoppelt oder von dieser getrennt werden kann. Die Spannungsquelle kann auch durch einen Netzspannungsanschluss oder durch Batterien oder Akkumulatoren realisiert sein.

Der Ausgang des steuerbaren Verstärkers 3 ist über eine weitere steuerbare Schaltvorrichtung 4 mit einer Primärwicklung 5 eines Transformators verbunden, welcher eine oder mehrere Sekundärwicklungen 6 aufweist. Über die Schaltvorrichtung 4 kann der Ausgang des Verstärkers 3 wahlweise mit der Primärwicklung 5 des Transformators (Position "1") oder einem Booster-Ausgang 9 der Transformatoranordnung (Position "0") verbunden werden.

Mindestens eine Sekundärwicklung 6 des Transformators ist in Abhängigkeit von der Einstellung der Schaltvorrichtung 11 mit der Spannungsquelle 1 verbunden (Position "0") oder von dieser getrennt, wobei dann die Spannungsquelle 1 mit dem Filter 2 verbunden ist (Position "1").

Eine weitere steuerbare Schaltvorrichtung 12 ist vorgesehen, um die Primärwicklung 5 des Transformators wahlweise mit dem Eingangsanschluss 13 zu verbinden (Position "1 ") oder davon zu trennen (Position "0").

Der steuerbare Verstärker 3 wird von einem Steuermittel 8 angesteuert, wobei das Steuermittel 8 in Form eines digitalen Signalprozessors, eines Mikrocontrollers, eines Mikroprozessors oder anderer digitaler Steuerlogik implementiert sein kann. Sensoren 7 an den Sekundärwicklungen 6 des Transformators erfassen das an der jeweiligen Sekundärwicklung auftretende Ausgangssignal, so dass das Steuermittel 8 davon abhängig die Verstärkung des Verstärkers 3 anpassen kann.

Zudem erfolgt über das Steuermittel 8 die Einstellung der steuerbaren Schaltvorrichtungen 4, 11 und 12, um durch entsprechende Kombination der Schalter- oder Relaisstellungen eine Vielzahl von unterschiedlichen Betriebsmodi realisieren zu können.

Um den Transformator im Normalbetrieb als Messtransformator betreiben zu können, werden die Schaltvorrichtungen 4 und 11 in die Position "1" und die Schaltvorrichtung 12 in die Position "0" geschaltet.

Wird die Schaltvorrichtung 11 hingegen in die Position "0" und die Schaltvorrichtung 12 in die Position "1" geschaltet, ist die Sekundärwicklung 6 mit der Spannungsquelle 1 bzw. mit Netz verbunden, während die Primärwicklung mit dem Filter 2 als Quelle für den Verstärker 3, der nun galvanisch von der Spannungsquelle 1 entkoppelt ist, verbunden ist, so dass der Transformator in diesem Betriebsmodus als Trenntransformator dient.

Der dargestellte Transformator, bei dem es sich um einen Leistungstransformator handeln kann, kann wie beschrieben über mehrere Sekundärwicklungen 6 und mehrere Anzapfungen oder Ausgänge 10 verfügen. Durch jede Sekundärwicklung 6 ist ein anderes Übersetzungsverhältnis definiert, so dass an jedem Ausgang 10 jeweils unterschiedliche Strom- und Spannungsamplituden auftreten. Auf diese Weise kann die Transformatoranordnung wahlweise mit verschiedenen Versorgungs-oder Netzspannungen betrieben und die Gesamtleistung erhöht werden. Beispielsweise kann auf diese Weise in diesem Betriebsmodus auch ein Drehstromanschluss realisiert werden, um einen höheren Ausgangsstrom zu erhalten.

Durch die Kombination der Einstellungsmöglichkeiten der Schaltvorrichtungen 4, 11, 12 kann eine Vielzahl von Einsatzmöglichkeiten der Transformatoranordnung erreicht werden. Die Einstellungen der Schaltvorrichtungen 4, 11, 12 und die entsprechenden Einsatzmöglichkeiten bzw. Betriebsmodi sind in der folgenden Tabelle dargestellt.

| Betriebsmodus | Schalter 11 | Schalter 12 | Schalter 4 |
|---|---|---|---|
| -- | 0 | 0 | 0 |
| Isolierter, geregelter Booster-Ausgang | 0 | 1 | 0 |
| Nicht isolierter, geregelter Booster-Ausgang | 1 | 0 | 0 |
| Parallelbetrieb von nicht isoliertem, geregeltem Booster-Ausgang und isoliertem, ungeregeltem Messtransformator | 1 | 1 | 0 |
| Nicht isolierte, ungeregelte Netzspannung am Transformator-Ausgang | 0 | 0 | 1 |
| -- | 0 | 1 | 1 |
| Isolierter, geregelter Messtransformator | 1 | 0 | 1 |
| -- | 1 | 1 | 1 |

Bei den mit "--" bezeichneten Betriebsmodi handelt es sich um nicht definierte Betriebsarten, welche in der Regel in der Praxis nicht verwendet werden.

## Patentansprüche

1. Transformatoranordnung, umfassend
einen Eingangsanschluss (13) zum Empfangen eines Eingangssignals, einen Transformator mit einer Primärwicklung (5) und einer Sekundärwicklung (6), und
Steuermittel (8) zum Steuern der Transformatoranordnung, **gekennzeichnet durch**
eine erste steuerbare Schaltvorrichtung (12), welche von den Steuermitteln (8) ansteuerbar ist, um wahlweise in einem ersten Betriebsmodus die Primärwicklung (5) des Transformators mit dem Eingangsanschluss (13) zu verbinden oder in einem zweiten Betriebsmodus die Primärwicklung (5) von dem Eingangsanschluss zu trennen, und
eine zweite steuerbare Schaltvorrichtung (11), welche von den Steuermitteln (8) ansteuerbar ist, um wahlweise in dem ersten Betriebsmodus die Sekundärwicklung (6) mit einer Versorgungsspannungsquelle (1) oder in dem zweiten Betriebsmodus die Sekundärwicklung von der Versorgungsspannungsquelle (1) zu trennen.

2. Transformatoranordnung nach Anspruch 1,
**dadurch gekennzeichnet**
**dass** die Versorgungsspannungsquelle (1) in dem zweiten Betriebsmodus über die zweite steuerbare Schaltvorrichtung (11) mit dem Eingangsanschluss (13) gekoppelt ist, so dass der Transformatoranordnung das von der Versorgungsspannungsquelle (1) zur Verfügung gestellte Eingangssignal zugeführt wird.

3. Transformatoranordnung nach Anspruch 1 oder 2,
**dadurch gekennzeichnet,**
**dass** die Steuermittel (8) einen digitalen Signalprozessor, einen Mikroprozessor,einen Mikrocontroller oder anderer digitaler Steuerlogik umfassen.

4. Transformatoranordnung nach einem der vorhergehenden Ansprüche,
**dadurch gekennzeichnet,**
**dass** zwischen den Eingangsanschluss (13) und der Primärwicklung (5) des Transformators eine Reihenschaltung aus einem Filter (2) und einem Verstärker (3) geschaltet ist.

5. Transformatoranordnung nach Anspruch 4,
**dadurch gekennzeichnet,**
**dass** der Verstärker (3) ein von den Steuermitteln (8) in Abhängigkeit von einem Ausgangssignal an der Sekundärwicklung (6) des Transformators gesteuerter Verstärker ist.

6. Transformatoranordnung nach Anspruch 4 oder Anspruch 5,
**dadurch gekennzeichnet,**
**dass** die Transformatoranordnung eine dritte steuerbare Schaltvorrichtung (4) umfasst, welche von den Steuermitteln (8) ansteuerbar ist, um wahlweise in dem zweiten Betriebsmodus den Verstärker (3) mit der Primärwicklung (5) des Transformators oder in einem dritten Betriebsmodus mit einem Ausgangsanschluss (9) der Transformatoranordnung zu verbinden.

7. Transformatoranordnung nach einem der vorhergehenden Ansprüche,
**dadurch gekennzeichnet,**
**dass** die Transformatoranordnung derart ausgestaltet ist, dass die Transformatoranordnung in dem ersten Betriebsmodus als Trenntransformatoranordnung und in dem zweiten Betriebsmodus als Messtransformatoranordnung betreibbar ist.

8. Messgerät umfassend eine Transformatoranordnung nach einem der vorhergehenden Ansprüche zur Umsetzung des dem Eingangsanschluss (13) der Transformatoranordnung zugeführten Eingangssignals in ein über einen Ausgangsanschluss (9, 10) der Transformatoranordnung ausgegebenes Messsignal.

9. Messgerät nach Anspruch 8,
**dadurch gekennzeichnet,**
**dass** das Messgerät als Messgerät für energietechnische Einrichtungen oder energietechnische Komponenten ausgestaltet ist.

10. Verfahren zum Betreiben einer Transformatoranordnung, welche einen Eingangsanschluss (13) zum Empfangen eines Eingangssignals und einen Transformator mit einer Primärwicklung (5) und einer Sekundärwicklung (6) umfasst,
**gekennzeichnet durch die Schritte**
wahlweise Verbinden der Primärwicklung (5) des Transformators mit dem Eingangsanschluss (13) in einem ersten Betriebsmodus der Transformatoranordnung oder Trennen der Primärwicklung (5) von dem Eingangsanschluss in einem zweiten Betriebsmodus der Transformatoranordnung, und
wahlweise Verbinden der Sekundärwicklung (6) des Transformators mit einer Versorgungsspannungsquelle (1) in dem ersten Betriebsmodus oder Trennen der Sekundärwicklung von der Versorgungsspannungsquelle (1) in dem zweiten Betriebsmodus.

11. Verfahren nach Anspruch 10,
**dadurch gekennzeichnet,**
**dass** das wahlweise Verbinden und Trennen über steuerbare Schaltvorrichtungen (11, 12), welche von Steuermitteln (8) gesteuert werden, erfolgt.

12. Verfahren nach Anspruch 10 oder Anspruch 11,
**dadurch gekennzeichnet,**
die Transformatoranordnung in dem ersten Betriebsmodus als Trenntransformatoranordnung und in dem zweiten Betriebsmodus als Messtransformatoranordnung verwendet wird.

13. Verfahren nach einem der Ansprüche 10-12,
**dadurch gekennzeichnet,**
**dass** die Transformatoranordnung als Transformatoranordnung nach einem der Ansprüche 1-7 ausgestaltet ist.
